# EUROPEAN PATENT APPLICATION

(11) **EP 4 528 942 A1**
(43) Date of publication of application: **26.03.2025**
(21) Application number: 24200221.0
(22) Date of filing: 13.09.2024
(51) Int. Cl.: H01S 5/00, H01S 5/14

(54) **TUNABLE LIGHT SOURCE WITH FREQUENCY GENERATOR**

(30) Priority: 19.09.2023 US 202363583759 P; 28.08.2024 US 202418818201
(71) Applicant: Daylight Solutions, Inc., San Diego CA 92127 (US)
(72) Inventor: PUSHKARSKY, Michael, San Diego (US); DAY, Timothy, San Diego (US)
(74) Representative: Viering, Jentschura & Partner mbB Patent- und Rechtsanwälte

(57) **Abstract**

A tunable light source (10) that generates a source beam (12) having a tunable source frequency (12a) includes an emitter assembly (14), a first frequency generator (16), and a first filter (18). The emitter assembly (14) emits an emitter beam (14a), and the first frequency generator (16) receives the emitter beam (14a) and generates a plurality of first frequency lines (16b). The first filter (18) filters the first frequency lines (16b) to transmit a first filter beam (18a) that includes only one of the first frequency lines (16b). The light source (10) can include a second frequency generator (20) that converts the first filter beam (18a) into a plurality of second frequency lines (20b), and a second filter (22) that filters the second frequency lines (20b) to provide a second filter beam (22a) having the source frequency (12a).

## Description

### BACKGROUND

Light sources that generate a source beam can be used in many fields such as Lidar, medical diagnostics, pollution monitoring, leak detection, analytical instruments, homeland security, remote chemical sensing, and industrial process control. Moreover, certain light sources may have applications in quantum applications such as quantum computing, sensing and precision navigation and timing.

In many applications, it is desirable to selectively tune an output frequency of the source beam generated by the light source over a tunable range. One type of tunable light source includes an external cavity laser arrangement having an intra-cavity frequency adjuster that is used to selectively tune the output frequency of the light source. Unfortunately, frequency adjusters take time to change and after they do, it takes a period of time for transient frequency noise in the light source to settle down. Further, the output frequency must be monitored with on-board metrology to determine if the absolute frequency of the output beam is actually equal to a desired target frequency. As a result thereof, the tuning time for this type of light source with a movable grating is in the second to millisecond range.

Manufacturers are always searching for ways to design a light source having a relatively large tuning range, an improved tuning speed, an improved absolute frequency accuracy, and a narrow linewidth for the source beam.

### SUMMARY

One implementation of a light source that generates a source beam having a source frequency includes: an emitter assembly, a first frequency generator, and a first filter. The emitter assembly emits an emitter beam, and the first frequency generator receives the emitter beam and generates a plurality of first frequency lines. The first filter filters the first frequency lines to transmit a first filter beam that primarily includes only one of the first frequency lines. The light source can include a second frequency generator that converts the first filter beam into a plurality of second frequency lines, and a second filter that filters the second frequency lines to provide a second filter beam that is approximately equal to a target frequency.

As an overview, the unique arrangement disclosed herein allows for the light source to be rapidly and accurately tuned over a broad spectral range utilizing the one or more frequency generators, and the one or more filters. Moreover, the light source can be accurately tuned without generating transient frequency noise that takes time to settle. Further, the light source can be designed so that the source beam has a narrow linewidth.

In another implementation, one of the first frequency lines of the first filter beam is selected. For example, the selected, first frequency line can be the first frequency line that best corresponds to the target frequency. In a specific example, the first frequency line that is closest to the target frequency is the selected, first frequency line. In this design, the first filter is tuned to transmit the selected first frequency line, while blocking the other first frequency lines.

The second frequency generator receives the first filter beam and convers the first filter beam into a second generator beam that consists of the plurality of discrete, spaced apart second frequency lines. The second filter can be tuned to filter the second generator beam to provide the second filter beam that includes only one of the second frequency lines.

The light source can include an amplifier that amplifies the second filter beam to provide the source beam. Additionally, or alternatively, the light source can include an optical fiber having a fiber facet that receives the source beam.

The first frequency lines of the first generator beam can be equally spaced, and/or the second frequency lines of the second generator beam can be equally spaced.

The second frequency generator can be tuned so that one of the second frequency lines is approximately equal to the target frequency, and the second filter can be tuned to transmit the second frequency line that is approximately equal to the target frequency, while blocking the other second frequency lines.

In one design, the first frequency generator generates at least ten, first frequency lines, and/or the second frequency generator generates at least one, second frequency lines.

In yet another implementation, the light source includes: an emitter assembly that emits an emitter beam; a first frequency generator that receives the emitter beam and generates a first generator beam that consists of a plurality of discrete, spaced apart, first frequency lines; a first filter that filters the first generator beam to transmit a first filter beam that includes only one of the first frequency lines; a second frequency generator that receives the first filter beam and converts the first filter beam into a second generator beam that consists of a plurality of discrete, spaced apart second frequency lines; and a second filter that filters the second generator beam to provide a second filter beam that includes only one of the second frequency lines. In this design, one of the first frequency lines of the first filter beam best corresponds to the target frequency; and the first filter is tuned to transmit the first frequency line that best corresponds to the target frequency, while blocking the other first frequency lines.

Further, the light source can include an amplifier that amplifies the second filter beam to provide the source beam, and/or an optical fiber having a fiber facet that receives the source beam. Moreover, the first frequency lines of the first generator beam can be equally spaced, and/or the second frequency lines of the second generator beam can be equally spaced.

Additionally, the second frequency generator can be tuned so that one of the second frequency lines is approximately equal to the target frequency, and the second filter can be tuned to transmit the second frequency line that best corresponds to the target frequency, while blocking the other second frequency lines.

In still another implementation, the light source includes: (i) an emitter assembly that emits an emitter beam; (ii) a first frequency generator that receives the emitter beam and generates a first generator beam that consists of a plurality of discrete, spaced apart, first frequency lines; (iii) a first filter that filters the first generator beam to transmit a first filter beam that includes only one of the first frequency lines; (iv) a second frequency generator that receives the first filter beam and converts the first filter beam into a second generator beam that consists of a plurality of discrete, spaced apart second frequency lines; and (v) a second filter that filters the second generator beam to provide a second filter beam. In this design, the second frequency generator can be selectively tuned so that one of the second frequency lines is approximately equal to the target frequency; and the second filter can be selectively tuned to transmit the second frequency line that is approximately equal to the target frequency, while blocking the other second frequency lines.

In this implementation, the light source can include one or more of: (i) an amplifier that amplifies the second filter beam to provide the source beam at the target frequency; and (ii) an optical fiber having a fiber facet that receives the source beam. Moreover, the first frequency lines of the first generator beam can be equally spaced, and the second frequency lines of the second generator beam can be equally spaced. Further, the first frequency generator can generate at least ten, first frequency lines, and the second frequency generator can generate at least three, second frequency lines.

In still another implementation, a method for generating a source beam having a source frequency that is tunable to a target frequency includes: emitting an emitter beam with an emitter assembly; converting the emitter beam to a first generator beam with a first frequency generator, the first generator beam including a plurality of discrete, spaced apart, first frequency lines, wherein one of the first frequency lines corresponds to the target frequency; and filtering the first generator beam with a first filter to transmit a first filter beam that includes only the first frequency line that corresponds to the target frequency.

Additionally, (i) the first filter beam can be converted into a second generator beam that consists of a plurality of discrete, spaced apart second frequency lines with a second frequency generator; and (ii) one of the second frequency lines can be approximately equal to the target frequency. Further, the method can include filtering the second generator beam with a second filter that is tuned to transmit the second frequency line that is approximately equal to the target frequency to provide a second filter beam, while blocking the other second frequency lines.

Moreover, the method can include amplifying the second filter beam to provide the source beam at the target frequency, and/or directing the source beam at a fiber facet of an optical fiber.

In another implementation, a light source that includes one or more of: (i) an emitter assembly; (ii) a first frequency generator; (iii) a first filter; (iv) a second frequency; and/or (v) a second filter. The light source is tunable to a target frequency and the emitter assembly emits an emitter beam.

The first frequency generator receives the emitter beam and generates a first generator beam that consists of a plurality of discrete, spaced apart, first frequency lines. In one implementation, one of the first frequency lines of the first generator beam is selected, and the first filter is tuned to transmit the selected, first frequency line, while blocking the other first frequency lines. For example, the selected, first frequency line corresponds to the target frequency. In another example, the selected, first frequency line best corresponds to the target frequency.

The second frequency generator receives the first filter beam and converts the first filter beam into a second generator beam that includes a second frequency line that is approximately equal to the target frequency.

The second filter filters the second generator beam to provide a second filter beam. In one example, the second filter is tuned to transmit the second frequency line that is approximately equal to the target frequency, while blocking the other second frequency lines.

### BRIEF DESCRIPTION OF THE DRAWINGS

The novel features of this invention, as well as the invention itself, both as to its structure and its operation, will be best understood from the accompanying drawings, taken in conjunction with the accompanying description, in which similar reference characters refer to similar parts, and in which:
Figure 1 is a simplified schematic illustration of an embodiment of a light source;
Figure 2 is a more detailed illustration of another implementation of the light source; and
Figure 3 is a simplified illustration of a portion of yet another implementation of the light source.

### DESCRIPTION

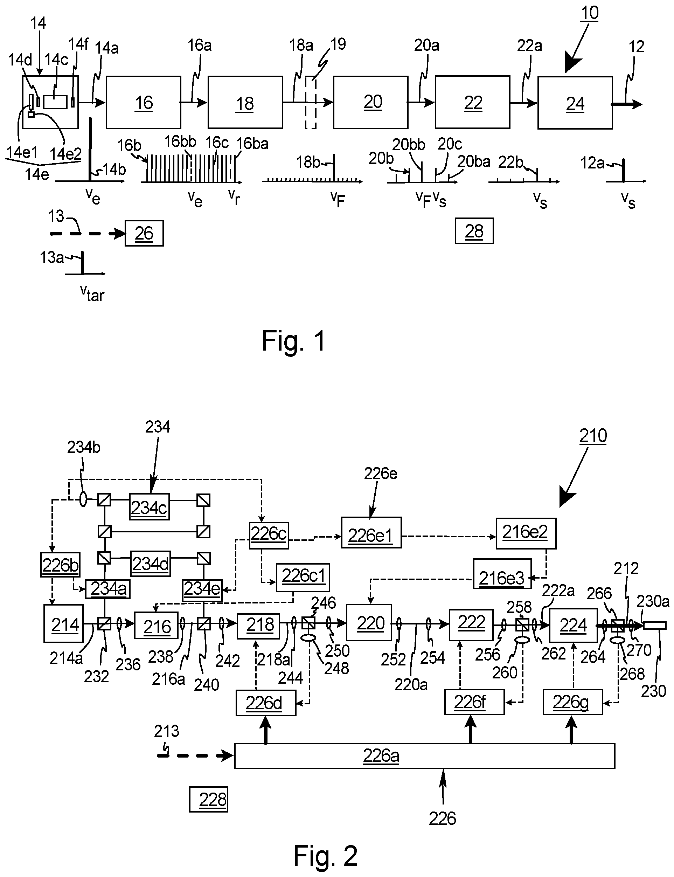

Figure 1 is simplified, block illustration of a first embodiment of a selectively tunable light source 10 that generates a source beam 12 (illustrated with an arrow) having a tunable, source frequency 12a. Figure 1 includes a graph that illustrates the single, source frequency "*νₛ*" 12a. The source beam 12 can alternatively be referred to as the output beam, and the source frequency 12a can alternatively be referred to as the output frequency. As provided herein, the light source 10 can receive a target frequency command 13 (illustrated with a dashed arrow), and be selectively tuned so that the source frequency 12a is approximately equal to a target frequency *"νₜₐᵣ"* in the target frequency command 13. Figure 1 includes a graph that illustrates the single, target frequency *"νₜₐᵣ"* 13a.

In certain embodiments, the light source 10 includes (i) an emitter assembly 14 that generates an emitter beam 14a (illustrated as an arrow); (ii) a first frequency generator 16 that receives the emitter beam 14a and generates a multiple frequency, first generator beam 16a that includes of a plurality of discrete, spaced apart, first frequency lines 16b; (iii) a first filter 18 that filters the first generator beam 16a and transmits a first filter beam 18a; (iv) a second frequency generator 20 that receives the first filter beam 18a, and generates a second generator beam 20a that consists of one or more second frequency lines 20b; (v) a second filter 22 that filters the second generator beam 20a and transmits a second filtered beam 22a; (vi) an amplifier 24 that amplifies the second filtered beam 22a to provide the source beam 12; and (vii) a system controller 26 that controls the operation of the light source 10.

Additionally, Figure 1 illustrates a power supply 28 (e.g., a battery, the electrical grid, or a generator) that provides electrical power to the components of the light source 10. It should be noted that the components of the light source 10 can be secured to a rigid mount (not shown) such as a test or experimental bench, a frame, a circuit board, or other structure. In a specific example, the light source 10 can be fabricated as a single heterogeneous photonic integrated circuit. This is a fundamental strength of the proposed architecture, offering a roadmap to an increased level of integration without compromising the performance as volumes and SWAP-C (size, weight, power and costs) requirements mature.

The design of each of the components of the light source 10 can be varied to change the performance and tunable range of the light source 10. Moreover, the light source 10 can be designed to include more or fewer components than are illustrated in Figure 1. For example, the light source 10 can be designed without the amplifier 24. Additionally, and optionally, the light source 10 can be designed to include an amplifier 19 (illustrated as a dashed box) after the first filter 18 that amplifies the first filter beam 18a prior to the second frequency generator 20. In this example, the amplifier 19 can be somewhat similar to the amplifier 24 described below. As yet another example, the light source 10 can be designed to include one or more lenses in Figure 1.

In Figure 1, the output beam 12 is illustrated as being launched into free space. Alternatively, for example, the light source 10 can be designed to include an optical fiber (not shown in Figure 1), and the output beam 12 can be fiber coupled.

In one, non-exclusive implementation, the system controller 26 selectively controls the components of the light source 10 to selectively tune the source frequency 12a to match the desired target frequency *"νₜₐᵣ"* 13a over a desired tuning range of the light source 10. For example, in this design, the system controller 26 receives or generates the target frequency command 13 for the single target frequency 13a, and the light source 10 is selectively tuned to adjust the value of the source frequency 12a to match the target frequency 13a.

As an overview, the unique arrangement disclosed herein allows for the light source 10 to be rapidly and accurately tuned over a broad spectral range. Moreover, the light source 10 can be accurately tuned without generating transient frequency noise that takes time to settle. Further, the light source 10 can be designed so that the source beam 12 has a narrow linewidth. As alternative, non-exclusive examples, the light source 10 can be designed and controlled to achieve one or more (e.g., all) of the following characteristics: (i) have a tuning switch time of less than 500, 200, 100, 50, 20, 10, 5, or 1 microseconds; (ii) have a tuning spectral range of at least 500, 200, 100, 50, 20, 10, or 5 nanometers; (iii) have a linewidth of less than approximately 200, 100, or 50 kilohertz; and/or (iv) an absolute frequency accuracy of 2, 1, or 0.5 megahertz or better. In one specific, non-exclusive implementation, the light source 10 can be tuned to any, single target frequency 13a in the 1137-1142 nanometer spectral range, with a one hundred kilohertz linewidth, a ten microsecond switch time, one megahertz absolute frequency accuracy, and provide at least 0.5 watts of output power.

In one implementation, the laser source 10 (without the system controller 26) is designed to have a size and weight of less than 0.25 cubic feet and less than five pounds, respectively. Further, the electronics of the system controller 26 can be integrated into a rack-mountable assembly with a size and weight less than one cubic foot and fifteen pounds, respectively.

As a non-exclusive example, the light source 10 can be designed so that the source beam 12 has an optical power of between 0.1 to 10 watts. Stated in another fashion, in alternative, non-exclusive embodiments, the light source 10 can be designed so that the source beam 12 has an optical power of at least approximately 0.1, 0.5, 1, 2, 5, or 10 watts. However, optical powers of less than or greater than those values are possible.

The emitter assembly 14 is controlled by the system controller 26 to generate the emitter beam 14a that is converted to the tunable source beam 12 by the other components of the light source 10. In one implementation, the emitter assembly 14 is designed so that the emitter beam 14a is locked to a single, emitter frequency *"νₑ"* 14b. In this design, the light source 10 is tunable without tuning the fixed frequency emitter assembly 14 and/or the first frequency generator 16. As a result thereof, there is no settling time for tuning the emitter assembly 14. This will improve the tuning switch time for the light source 10.

Figure 1 includes a graph that illustrates the single, emitter frequency 14b. In this implementation, the design of the emitter assembly 14 can be varied to achieve the desired characteristics of the emitter beam 14a (e.g., the emitter frequency and line width), and the desired tuning range of the light source 10. In one, non-exclusive design, the emitter frequency 14b is within the desired tuning range of the light source 10.

In one, non-exclusive, specific implementation, the emitter assembly 14 is a fixed frequency, external cavity semiconductor laser that is locked to the single emitter frequency 14b. In this implementation, the fixed frequency, external cavity semiconductor laser may utilize closed loop feedback to maintain the desired emitter frequency 14b. In a specific, non-exclusive design, the fixed frequency, external cavity emitter assembly 14 may utilize Doppler-free absorption spectroscopy to maintain the desired emitter frequency 14b of the emitter beam 14a.

Figure 1 illustrates a non-exclusive example of a suitable emitter assembly 14. In this design, (i) the emitter assembly 14 includes a gain medium 14c, (ii) a cavity optical assembly 14d, (iii) a wavelength selective ("WS") feedback assembly 14e, and (iv) an emitter output optical assembly 14f. The design of each of these components can be varied.

In this embodiment, the gain medium 14c can include (i) a first facet that faces the cavity optical assembly 14d and the wavelength selective element 14e, and (ii) a second facet that faces the emitter output optical assembly 14f; and the gain medium 14c emits from both facets. In one embodiment, the first facet is coated with an anti-reflection ("AR") coating, and the second facet is coated with a partly reflective coating. With this design, the reflective second facet of the gain medium 14c acts as a first end (output coupler) of an external cavity for the emitter assembly 14, and the wavelength selective element 14e defines a second end of the external cavity.

As non-exclusive examples, the gain medium 14c can be made of an Gallium Antimonide, Gallium arsenide, indium phosphide, gallium nitride, Indium Gallium Phosphide, Indium Gallium Nitride, Aluminum Gallium Arsenide, Aluminum Gallium Indium Phosphide, or Indium Gallium Arsenide Phosphide. Alternatively, for example, the gain medium 14c can be a Quantum Cascade ("QC") gain medium, or an interband cascade laser.

The cavity optical assembly 14d is positioned between the gain medium 14c and the feedback assembly 14e. The cavity optical assembly 14d collimates and focuses the beam that passes between these components. The cavity optical assembly 14d can include one or more lenses. The emitter output optical assembly 14f collimates and focuses the emitter beam 14a. The emitter output optical assembly 14f can include one or more lenses. The type of material utilized for each lens can be selected to work with the wavelength of the emitter beam 14a.

The wavelength selective element 14e reflects the beam back to the gain medium 14c, and is used to precisely select and adjust the lasing frequency of the emitter assembly 14. In this manner, the emitter beam 14a may be tuned with the wavelength selective element 14e without adjusting the gain medium 14c. Thus, with the external cavity arrangement disclosed herein, the wavelength selective element 14e dictates what frequency will experience the most gain for the emitter assembly 14. As a result of this design, the emitter assembly 14 is tunable independently of the light source 10.

A number of alternative embodiments of the wavelength selective element 14c can be utilized. In Figure 1, the wavelength selective element 14c can include a grating 14e1, a grating mover 14e2 (e.g. a voice coil actuator), and a feedback detector (not shown). The grating mover 14e2 selectively moves (e.g. rotates about an axis) the grating 14e1 to rapidly adjust the lasing frequency of the respective gain medium 14c. Further, the rotational position and/or movement of the grating 14e1 can be continuously monitored with the feedback detector that provides for closed loop control of the grating mover 14e2.

Alternatively, for example, the wavelength selective feedback assembly 14e can have another design. A discussion of the techniques for realizing the full laser tuning range from a semiconductor device can be found in M. J. Weida, D. Caffey, J. A. Rowlette, D. F. Arnone and T. Day, "Utilizing broad gain bandwidth in quantum cascade devices", Optical Engineering 49 (11), 111120-111121 - 111120-111125

(2010). As far as permitted, the contents of this article are incorporated herein by reference.

The desired value of the emitter frequency 14b can be selected to achieve the desired tuning range of the light source 10. In a specific example, the emitter frequency 14b is selected to be near an absorption line of a suitable small-molecule gas, (e.g., near 1142 nanometers) for ease of closed loop feedback control of the emitter assembly 14 using that suitable small-molecule gas in a reference cell (not shown in Figure 1). In non-exclusive examples, the emitter assembly 14 can be designed and controlled so that the emitter frequency 14b is a single frequency in the ultraviolet range, the visible range, the near infrared range, the infrared range, the mid-infrared range, the far infrared range, the Terahertz range, or some other range. However, other values for emitter frequency 14b can be utilized.

In certain implementations, the emitter assembly 14 is designed to have a narrow linewidth. In alternative, non-exclusive implementations, the emitter assembly 14 is designed and operated so that the emitter beam 14b has a linewidth of less than approximately 200, 100, or 50 kilohertz. It should be noted that in certain designs, the linewidth of the output beam 12 corresponds to the linewidth of the emitter beam 14a.

The amount of power generated by the emitter assembly 14 can also be varied. In alternative, non-exclusive examples, the emitter assembly 14 is designed and controlled to generate the emitter beam 14a having a power of between 1 to 1000 milliwatts. However, other powers are possible.

Still alternatively, the emitter assembly 14 can be designed to be a fixed frequency laser without an external cavity.

It should be noted that the emitter assembly 14 can alternatively be referred to as a "seed laser" or "laser".

Additionally, it should be noted that the emitter beam 14a can be sampled with a sensor (e.g., a photodiode) to ensure that the emitter assembly 14 is generating and locked to the desired emitter beam 14a.

The first frequency generator 16 receives the emitter beam 14a, and is controlled by the system controller 26 to convert the emitter beam 14a into the multiple frequency, first generator beam 16a that consists of the series of discrete, spaced apart, first frequency lines 16b. Figure 1 includes a graph that illustrates the plurality of first frequency lines 16b. In one design, the single emitter frequency 14b of the emitter beam 14a is received by the first frequency generator 16 and converted to the multi-frequency, first generator beam 16a that consists of the plurality of discrete, spaced apart, first frequency lines 16b.

In one implementation, the first frequency generator 16 is an electro-optical comb generator that is controlled by the system controller 26. A suitable first frequency generator 16 includes an optical device (e.g., an optical crystal) that receives the emitter beam 14a, and the system controller 26 directs a current (e.g., a sinusoidal current with a RF frequency) to the optical device to create the first generator beam 16a including the plurality of first frequency lines 16b. In this design, the RF frequency can be modulated to create the desired number and spacing of the frequency lines 16b. Alternatively, for example, the first frequency generator 16 may include one or more microresonators.

It should be noted that the first frequency generator 16 receives the emitter beam 14a at the emitter frequency 14b and converts that emitter beam 14a into the first generator beam 16a that includes the emitter frequency 14b and a plurality of first sidebands (first side modes) 16ba. In this design, the emitter frequency 14b can be referred to as a first carrier frequency 16bb, and the first sidebands 16ba can be symmetrical to the first carrier frequency 16bb. Further, the carrier frequency 16bb and the sidebands 16ba make up the first frequency lines 16b of the first generator beam 16a.

Typically, during the conversion of the emitter beam 14a by the first frequency generator 16, the amplitude of the carrier frequency 16bb is reduced to make the sidebands 16ba. In one implementation, the first frequency generator 16 can be selectively controlled to selectively adjust the amplitude of the carrier frequency 16bb and the amplitude of the sidebands 16ba. In Figure 1, the first generator beam 16a is represented as having equal amplitudes for the sidebands 16ba and the carrier frequency 16bb. Alternatively, for example, the first frequency generator 16 can be controlled so that one or more of the sidebands 16ba and/or the carrier frequency 16bb has a different amplitude.

Moreover, the first frequency generator 16 can be selectively controlled to selectively adjust the number and spacing of first sidebands 16ba (and the frequency lines 16b). In alternative, non-exclusive examples, the first frequency generator 16 can be designed and controlled to generate at least approximately 4, 10, 20, 30, 40, 50, 60, 70, 80, or 100 spaced apart, first sidebands 16ba (or at least approximately 5, 11, 21, 31, 41, 51, 61, 71, 81, or 101 spaced apart, first frequency lines 16b). Further, in alternative, non-exclusive examples, the first frequency generator 16 can be designed and controlled so that the first frequency lines 16b are spaced apart at least 0.01, 0.1, 1, 10, 20, 30, 40, 50, 60, 70, 80, or 100 gigahertz. However, other values are possible.

In one design, the first frequency generator 16 is not tuned in response to the target frequency command 13. Stated differently, a constant set of first frequency lines 16b is generated by the first frequency generator 16 regardless of the target frequency 13a in the target frequency command 13. As a result, there will be no settling time for the first frequency generator 16 when a different target frequency command 13 is generated. This will result in faster tuning times for the light source 10. Alternatively, the first frequency generator 16 can be controlled to selectively generate a different set of first frequency lines 16b for different target frequency commands 13.

In the non-exclusive implementation of Figure 1, the first frequency generator 16 has generated twenty sidebands 16ba. In one specific implementation, the spacing frequency can be made as high as possible (to minimize the number of first frequency lines 16b), but will be at least thirty gigahertz and possibly up to fifty gigahertz. The exact spacing of the first frequency lines 16b can be determined by locking one of the first frequency lines 16b (e.g., a reference frequency line "*νᵣ*" ) to the second suitable absorption line within the 1137-1147 nanometer range using a reference cell (not shown in Figure 1).

As provided herein, in certain implementations, the possible tuning range of the light source 10 can be adjusted by adjusting the number and spacing of the first frequency lines 16b generated by the first frequency generator 16.

As provided above, in one implementation, the first frequency generator 16 is designed and controlled so that the first frequency lines 16b are substantially equally spaced apart, the first sidebands 16ba are centered about the carrier frequency *νₑ* 16bb, and each of the frequency lines 16b has approximately the same amplitude (intensity). Alternatively, for example, the first frequency generator 16 can be designed and controlled so that the first frequency lines 16b have unequal amplitudes.

In the non-exclusive example of Figure 1, the first frequency generator 16 has generated twenty sidebands 16b. In this example, the plurality of first frequency lines 16b includes one first frequency line that is at the emitter frequency *νₑ*, and another first frequency line at the reference frequency *νᵣ*. In this design, the emitter frequency *νₑ* and the first reference frequency *νᵣ* can be used in the closed loop control of the first frequency generator 16 by the system controller 26. Stated alternatively, a "dual line" locking scheme can be utilized to stabilize the first frequency generator 16 in absolute frequency "space" and will generate an onboard absolute RF frequency clock. With this design, the difference between the two optical frequencies (the "beat note") may reside in the RF region in which it may be conveniently monitored and (optionally) compared to readily available RF frequency references. Additionally, if the reference optical beam is stabilized (locked) to a reference like a molecular, atomic, ionic transition, or some other stable reference, then fluctuations in the monitored RF frequency may be ascribed to variations in the frequency of the unlocked optical "line". This RF "error signal" may be used to control the frequency of that line, locking it, scanning it, or controlling the frequency in any of a variety of ways within the bandwidth of the RF control loop.

As provided herein, the system controller 26 receives the target signal command 13, reviews the target frequency 13a, reviews the first frequency lines 16b, and selects a selected, first frequency line 16c that can be used for the generation of the source beam 12. In one implementation, the system controller 26 selects the first frequency line 16c that corresponds to the target frequency 13a. For example, "corresponds" can mean the first frequency line 16b that allows for the generation of the source beam 12 at the target frequency 13a. In specific example, "corresponds" can mean one of the two closest first frequency lines 16c to the target frequency 13a. In this example, the target frequency 13a can be located between two of the first frequency lines 16b, and either of these two, first frequency lines 16b can be the selected, first frequency line 16c.

In a more specific example, the system controller 26 reviews the first frequency lines 16b, and selects the selected, first frequency line 16c that best corresponds to the target frequency 13a. In this example, "best corresponds" can mean the first frequency line 16b that is closest to the target frequency 13a. As a result, the first frequency line 16b that is closest to the desired target frequency 13a becomes the selected, first frequency line 16c. Stated alternatively, the system controller 26 reviews the plurality of generated first frequency lines 16b, and selects the first frequency line 16c that best corresponds (e.g., is closest) to the desired target frequency 13a of the target signal command 13.

As provided herein, the selected, first frequency line 16c will vary and correspond to the target signal command 13. In one design, the selected, first frequency line 16c will be within approximately thirty Gigahertz of the target frequency 13a. In alternative, non-exclusive implementations, the selected, first frequency line 16c is within approximately 10, 20, 25, 35, 40, 50, or 100 Gigahertz of the target frequency 13a.

After the selected, first frequency line 16 is determined, the system controller 26 controls the first filter 18 so that the one, selected first frequency line 16c is transmitted, and the other first frequency lines 16b are blocked. As a result, the first filter 19 is controlled to transmit (select) the single, first filter frequency 16c that corresponds to the desired target frequency 13a. In one example, the first filter 18 is controlled to transmit (select) the first frequency line 16c that best corresponds to the desired target frequency 13a, while blocking the rest of the first frequency lines 16b.

Stated differently, the first filter 18 receives the multi-frequency, first generator beam 16a, and is controlled (tuned) by the system controller 26 to generate the first filtered beam 18a having a desired, first filter frequency "*ν_{F}*" 18b. In this example, when the first filter 18 is properly controlled, the desired, first filter frequency 18b is equal to the selected, first filter frequency 16c that has been transmitted through the first filter 18.

As provided herein, the first filter 18 can be selectively controlled (tuned) to transmit the selected, first filter frequency 16c, while blocking the rest (non-selected, first filter frequencies) of the spectrum of the first generator beam 16a. Figure 1 includes a graph that illustrates the desired, first filter frequency "*ν_{F}*" 18b that is equal to the selected, first filter frequency 16c. As used herein, in one implementation, (i) "transmit the selected, first filter frequency 16c" shall mean that at least twenty-five percent of the selected first filter frequency 16c is transmitted through the first filter 18; and (ii) "blocking the rest of the spectrum of the first generator beam 16a" shall mean that less than two percent of the rest of the spectrum of the first generator beam 16a is transmitted through the first filter 18. In alternative, non-exclusive implementations, (i) "transmit the selected, first filter frequency 16c" shall mean that at least 30, 40, 50, 60, 70, or 80 percent of the selected first filter frequency 16c is transmitted through the first filter 18; and (ii) "blocking the rest of the spectrum of the first generator beam 16a" shall mean that less than 10, 5, 1, or 0.1 percent of the rest of the spectrum of the first generator beam 16a is transmitted through the first filter 18.

In this implementation, the first filter 18 is controlled and the desired, first filter frequency "*ν_{F}*" 18b is selected based on the target frequency 13a in the target frequency command 13. Thus, the first filter 18 is controlled so that a different desired, first filter frequency "*ν_{F}*" 18b can be used for different target frequencies 13a. Stated differently, (i) the value of the selected, first filter frequency 16c is based on the value of the target frequency 13a; and (ii) the first filter 18 is controlled to transmit (select) the selected, first frequency line 16c, while blocking the rest of the first frequency lines 16b.

In this design, the first filter 18 filters the first generator beam 16a to transmit the first filter beam 18a that primarily includes only one of the first frequency lines 16b, namely the selected, first frequency line 16c. As provided herein, "primarily includes" means that the amplitude of the selected, first frequency line 16c in the first filter beam 18a is at least twenty-five percent greater than the amplitude of any of the other (non-selected) first frequency lines 16b in the first filter beam 18a.

In one implementation, the first filter 18 is a tunable drop filter that is controlled by the system controller 26 to transmit only one of the first frequency lines 16b, while blocking the other first frequency lines 16b. In a specific example, the first filter 18 can be an electro-optically tunable micro-resonator which can be tuned via the control voltage. Alternatively, for example, the first filter 18 can have another type of filter.

In one implementation, the first filter 18 can be designed and controlled to transmit the single, selected, first frequency line 16c, with a thirty dB rejection ratio for the other (non-selected), first frequency lines 16b. Stated differently, depending upon the target frequency 13, the first filter 18 can be controlled to transmit any one of the first frequency lines 16b, while blocking all the others. The system controller 26 will determine the selected, first frequency line 16c based on the target frequency 13a, and provide control voltage(s) to the first filter 18. It should be noted that the first filter beam 18a can be sampled with a sensor (e.g., a photo diode) to ensure that the filter pass band of the first filter 18 is coincident with the selected, first frequency line 16c that corresponds to the target frequency 13a.

The second frequency generator 20 receives the first filter beam 18a, and is controlled by the system controller 26 to convert the first filter beam 18a into the second generator beam 20a that includes at least one, second frequency line 20b. In one implementation, the second frequency generator 20 is controlled to create the second generator beam 20a having a second frequency line 20c that is approximately equal to the target frequency 13a.

In the non-exclusive implementation of Figure 1, the second frequency generator 20 has generated a multi-frequency, second generator beam 20a that includes a series of discrete, spaced apart, second frequency lines 20b, with one of the second frequency lines 20c that is approximately equal to the target frequency 13a.

Figure 1 includes a graph that illustrates the plurality of second frequency lines 20b. In one design, the single, first filter frequency 18b is received by the second frequency generator 20 and converted to the second generator beam 20a. In one implementation, the second frequency generator 20 is an electro-optical phase modulator. A suitable second frequency generator 20 includes an optical device that receives the first filter beam 18a, and the system controller 26 directs a current with modulating phase to the optical device to create and generate the plurality of second frequency lines 20b. In this design, the phase can be modulated to create the desired number and spacing of the second frequency lines 20b to achieve the second frequency line 20c that is approximately equal to the target frequency 13a. Alternatively, for example, the second frequency generator 20 can have another type of optical modulator.

In the non-exclusive example of Figure 1, the second frequency generator 20 converts the first filter beam 18a into the second generator beam 20a that includes the first filter frequency 18b and a plurality of second sidebands (second side modes) 20ba. The first filter frequency 18b can be referred to as a second carrier frequency 20bb, and the second sidebands 20ba can be symmetrical to the second carrier frequency 20bb. Further, the second carrier frequency 20bb and the second sidebands 20ba make up the second frequency lines 20b of the second generator beam 20a.

During the conversion of the first filter beam 18a by the second frequency generator 20, the amplitude of the second carrier frequency 20bb is reduced to make the second sidebands 20ba. In one implementation, the second frequency generator 20 can be selectively controlled to selectively adjust the amplitude of the second carrier frequency 20bb and the amplitude of the second sidebands 20ba. In Figure 1, the second generator beam 20a is represented as having non-equal amplitudes for the second sidebands 20ba and the second carrier frequency 20bb. In this example, the amplitude of the second carrier frequency 20bb is greater than the amplitude of the second sidebands 20ba. Alternatively, the second frequency generator 20 can be controlled so that the amplitude of one more of the second sidebands 20ba is greater than the amplitude of the second carrier frequency 20bb.

Moreover, the second frequency generator 20 can be selectively controlled to selectively adjust the number and spacing of second sidebands 20ba (and the second frequency lines 20b). In alternative, non-exclusive examples, the second frequency generator 20 can be designed and controlled to generate at least approximately 2, 4, or 6 spaced apart, second sidebands 20ba (or at least approximately 3, 5, or 7 spaced apart, second frequency lines 20b). Further, in alternative, non-exclusive examples, the second frequency generator 20 can be designed and controlled so that the second frequency lines 20b are spaced apart at least 0.1, 1, 10, 30, or 50 gigahertz. However, other values are possible.

In one implementation, the second frequency generator 20 is designed and controlled so that the second frequency lines 20b are substantially equally spaced apart, the second sidebands 20ba are centered by the first filter frequency *ν_{F}*, and amplitude of the second frequency lines 20b decreases away from the first filter frequency *ν_{F}*. Alternatively, the second frequency generator 20 can be designed and controlled so that the second frequency lines 20b are unequally spaced and/or have equal amplitudes.

In a specific example, the second frequency generator 20 can be designed and controlled to generate the one, second frequency line 20c that is at (approximately equal to) the target frequency 13a, with as much power as possible.

In the non-exclusive example of Figure 1, the second frequency generator 20 has generated five, spaced apart, second frequency lines 20b from the first filter beam 18a. In this example, the second frequency lines 20b includes the second carrier frequency 20bb that is at the first filter frequency *ν_{F}*, and an equal, second frequency line 20c that is at (approximately equal to) the target frequency *νₜₐᵣ* 13a. In this design, the system controller 26 receives or generates the target signal command 13. Subsequently, the system controller 26 controls the second frequency generator 20 so that one of the generated second frequency lines 20c is approximately equal to the target frequency *νₜₐᵣ* 13a. Stated alternatively, when the light source 10 is being tuned, the system controller 26 selectively adjusts the second frequency generator 20 so that one of the second frequency lines 20c (e.g., *νₛ*) is approximately equal to the target frequency *νₜₐᵣ* 13a. As used herein, as non-exclusive examples, the term "approximately equal" shall mean within approximately 5, 10, 15, 20, 25, 30, 40, 50, or 100 kilohertz of the target frequency *νₜₐᵣ* 13.

With this design, the second frequency generator 20 is controlled to selectively adjust the number and spacing of second frequency lines 20b to correspond to the target signal command 13. Stated differently, the second frequency generator 20 is tuned in response to the target frequency command 13.

The system controller 26 can determine the correct modulation frequency for the second frequency generator 20 using the output of an absolute RF frequency clock previously generated, in combination with a frequency divider and a phase-locked loop.

The second filter 22 receives the second generator beam 20a, and is controlled by the system controller 26 to generate the second filter beam 22a that has the second filter frequency 22c that best corresponds (e.g., is approximately equal) to the desired, target frequency *νₜₐᵣ* 13a. Stated alternatively, the second filter 22 can be selectively controlled (tuned) to transmit the desired, second filter frequency "*νₛ*" 22c, while blocking the rest of the spectrum of the second generator beam 22a. Figure 1 includes a graph that illustrates the equal, second filter frequency 22c. It should be noted that if the second filter 22 is properly controlled, the source frequency 12a will be equal to the second filter frequency 22c.

As used herein, in one implementation, (i) "transmit the desired, second filter frequency 22c" shall mean that at least twenty-five percent of the desired, second filter frequency 20c is transmitted through the second filter 22; and (ii) "blocking the rest of the spectrum of the second generator beam 20a" shall mean less than two percent of the rest of the spectrum of the second generator beam 20a is transmitted through the second filter 22. In alternative, non-exclusive implementations, (i) "transmit the desired, second filter frequency 22c" shall mean that at least 30, 40, 50, 60, 70, or 80 percent of the desired, second filter frequency 22c is transmitted through the second filter 22; and (ii) "blocking the rest of the spectrum of the second generator beam 20a" shall mean that less than 10, 5, 1, or 0.1 percent of the rest of the spectrum of the second generator beam 16a is transmitted through the second filter 22.

In this design, the second filter 22 filters the second generator beam 20a to transmit the second filter beam 22a that primarily includes only one of the second frequency lines 20b, namely the equal, second frequency line 20c. As provided herein, "primarily includes" means that the amplitude of the equal, second frequency line 20c in the second filter beam 22a is at least twenty-five percent greater than the amplitude of any of the other (non-selected) second frequency lines 20b in the second filter beam 22a.

In this implementation, the system controller 26 receives or generates a target signal command 13. Subsequently, the second filter 22 is controlled to transmit (select) the equal, second frequency line 20c that is approximately equal to the desired target frequency 13a, while blocking the rest of the second frequency lines 22b. With this design, the second frequency line 20c that is approximately equal to the desired target frequency 13a becomes the second filtered beam 22a.

In one implementation, the second filter 22 is a tunable drop filter that is controlled by the system controller 26 to transmit only one of the second frequency lines 20b, while blocking the other second frequency lines 20b. Alternatively, for example, the second filter 22 can be a different type of filter.

It should be noted that the second filter beam 22a can be sampled with a sensor (e.g., a photo diode) to ensure that the filter pass band of the second filter 22 is coincident with the target frequency 13a.

The amplifier 24 amplifies the second filter beam 22a to provide the source beam 12. With this design, the amplifier 24 amplifies the second filter beam 22a without changing the second filter frequency 22b of the second filter beam 22a.

The design of the amplifier 24 can be varied. In one design, the amplifier 24 can be an electronic device that increases the magnitude of the second filter beam 22a without changing the frequency. In alternative, non-exclusive implementations, the amplifier 24 can be controlled by the system controller 26 to increase the magnitude of the second filter beam 22a at least approximately two to thirty decibels.

The system controller 26 controls the operation of the components of the light source 10 to generate the desired source beam 12 at the desired, source frequency 12a. For example, the system controller 26 can include one or more processors, and one or more electronic storage devices. Additionally, the system controller 32 can include one or more feedback devices (not shown in Figure 1) that provides feedback that is used to control one or more of the components in a closed loop fashion.

In Figure 1, the system controller 26 is illustrated as a single system. Alternatively, the system controller 26 can be a distributed system.

In one, non-exclusive implementation, the system controller 26 selectively controls the components of the light source 10 to selectively tune a desired source frequency "*νₛ*" 12a of the source beam 12 over a desired tuning range of the light source 10. For example, in this design, the system controller 26 can receive or generate the target frequency command 13, and the light source 10 is tunable to selectively adjust the value of the source frequency 12a to match the target frequency 13a from the target frequency command 13.

In certain implementations, the system controller 32 can control (i) the electron injection current to the emitter assembly 14; (ii) control the first frequency generator 16a to generate the desired the first frequency lines 16b; (iii) control the first filter 18 to generate the desired first filter beam 18a; (iv) control the second frequency generator 20 to generate the desired the second frequency lines 20b; (v) control the second filter 22 to generate the desired second filter beam 22a; and (vi) control the amplifier 24 to generate the desired output beam 12.

In the arrangement of Figure 1, the emitter assembly 14 is locked to a single, emitter frequency *"νₑ"* 14b, and the system controller 26 selectively tunes the first frequency generator 16a, the first filter 18, the second frequency generator 20, and the second filter 22 in response to a target frequency command 13. In this design, the light source 10 is tunable without tuning the fixed frequency emitter assembly 14. As a result thereof, there is no settling time for the emitter assembly 14 caused by tuning of the laser source 10. Further, the system controller 26 can very rapidly tune the first frequency generator 16a, the first filter 18, the second frequency generator 20, and the second filter 22. This will result in very fast tuning switch times for the light source 10.

Figure 2 is a simplified block illustration of another implementation of the tunable light source 210 that generates a source beam 212 having a tunable, desired source frequency 12a (illustrated in Figure 1). In Figure 2, the light source 210 includes (i) an emitter 214; (ii) a first frequency generator 216; (iii) a first filter 218; (iv) a second frequency generator 220; (v) a second filter 222; (vi) an amplifier 224; (vii) a system controller 226; and (viii) a power supply 228 that are somewhat similar to the corresponding components described above and illustrated in Figure 1. However, the implementation of Figure 2 is a fiber coupled design that includes an optical fiber 230, and the source beam 212 can be directed at an inlet facet 230a of the optical fiber 230.

Moreover, the non-exclusive implementation of Figure 2, the system controller 226 is a distributed system that includes multiple controllers and feedback loops that are used to control the components of the laser assembly 210 in a closed loop fashion for improved accuracy. Stated differently, Figure 2 provides a more detailed, non-exclusive illustration of the system architecture of the light source 210, including additional components (e.g., sensors, beam splitters, lenses, and other components), and a more detailed illustration of the control of the components of the laser assembly 210.

As an overview, in Figure 2, the system controller 226 includes (i) a logic/control module 226a, (ii) an emitter control module 226b that controls the emitter assembly 214, (iii) a first frequency generator, feedforward loop control module 226c that controls the first frequency generator 216, (iv) a first filter control module 226d that controls the first filter 218, (v) a second frequency generator, feedforward loop control module 226e that controls the second frequency generator 220, (vi) a second filter control module 226f that controls the second filter 222, and (vii) an amplifier control module 226g that controls the amplifier 224. The design of each of these modules can be varied pursuant to the teachings provided herein.

In the implementation of Figure 2, the emitter control module 226b is used to control the emitter assembly 214 in a closed loop fashion. In this implementation, the fixed frequency, external cavity emitter assembly 214 utilizes closed loop feedback to accurately maintain the desired emitter frequency 14b (illustrated in Figure 1).

In the non-exclusive implementation of Figure 2, the light source 210 includes a first beam splitter 232 that splits the emitter beam 214a, and diverts a portion of the emitter beam 214a to a first sensor system 234, and the rest of the emitter beam 214a through a first lens 236 to the first frequency generator 216. In this design, the first sensor system 234 can be used in the closed loop control of the emitter 214 so that the emitter beam 214a is locked to a single, emitter frequency *"νₑ"* 14b (illustrated in Figure 1).

In one, non-exclusive implementation, the first sensor system 234 can include a low frequency, first phase modulator 234a, a photodetector 234b, a reference cell 234c, an optical bandpass filter 234d, and a low frequency, second phase modulator 234e.

In Figure 2, the emitter control module 226b receives feedback from the photodetector 234b for the closed loop control of the emitter assembly 214 to ensure that the emitter assembly 214 is generating and locked to the desired emitter beam 214a.

The first frequency generator, feedforward loop control module 226c controls the first frequency generator 216 so that the first frequency generator 216 accurately generates the desired first frequency lines 16b (illustrated in Figure 1). In Figure 2, (i) a second lens 238 collimates the first generator beam 216a; (ii) a second beam splitter 240 splits the first generator beam 216a, diverts a portion of the first generator beam 216a to the first sensor system 234, and the rest through a third lens 236 to the first filter 218.

In this design, the feedforward loop control module 226c can be used to control the exact spacing frequency of the first frequency lines 16b by locking one of the first frequency lines 16b to the second suitable absorption line (e.g., within the 1137-1147 nanometer range). The feedforward loop control module 226c can include a radio frequency amplifier 226c1.

It should be noted that in the non-exclusive implementation of Figure 2, the emitter control module 226b and the first generator module 226c both use the same photodetector 234b and reference cell 234c. Alternatively, the system controller 226 can be designed so that the emitter control module 226b and the first generator module 226c are independent of each other with independent detectors, independent reference cells, and/or independent electronics.

With reference to Figures 1 and 2, the plurality of first frequency lines 16b includes one first frequency line that is at the emitter frequency *νₑ*, and another first frequency line at a reference frequency *νᵣ*. In this design, the emitter frequency *νₑ* and the first reference frequency *νᵣ* can be used in the closed loop control of the first frequency generator 16 by the control module 226c. Stated alternatively, a "dual line" locking scheme can be utilized to stabilize the first frequency generator 216 in absolute frequency "space" and will generate an onboard absolute RF frequency clock. With this design, the difference between the two optical frequencies (the "beat note") may reside in the RF region in which it may be conveniently monitored and (optionally) compared to readily available RF frequency references. Additionally, if the reference optical beam is stabilized (locked) to a reference like a molecular, atomic, ionic transition, or some other stable reference, then fluctuations in the monitored RF frequency may be ascribed to variations in the frequency of the unlocked optical "line". This RF "error signal" may be used to control the frequency of that line, locking it, scanning it, or controlling it's frequency it any of a variety of ways within the bandwidth of the RF control loop.

The first filter control module 226d controls the first filter 218 in a closed loop fashion. As provided above, the first filter 218 is controlled to transmit any one single, first frequency line 16b. Stated differently, depending upon the target frequency command 213, the first filter 218 can be selectively controlled to transmit any one of the first frequency lines 16b, while blocking all the others. For example, the first filter control module 226d can control the first filter 218 to transmit the desired first frequency line 16b that best corresponds to the target frequency command 213.

In Figure 2, (i) a lens 244 directs the first filter beam 218a; (ii) a beam splitter 246 splits the first filter beam 218a, and diverts a portion of the first filter beam 218a to a sensor 248 (e.g., a photodetector), and (iii) a lens 250 directs the first filter beam 218a at the second frequency generator 220. In this design, the first filter beam 218a is sampled with the sensor 248 to ensure that the filter pass band of the first filter 218 is coincident with the desired first frequency line 16b that corresponds to the target frequency command 213. With this design, the information from the sensor 248 is directed to the first filter module 226d to control the first filter 218 in a closed loop fashion.

The second frequency generator 220 creates the second generator beam 220a, with one, second frequency line being at the target frequency of the target frequency command 213. In Figure 2, the second generator module 226e precisely controls the second frequency generator 220 in a closed loop fashion. In this design, the second generator module 226e includes a frequency divider 226e1, a phase-lock loop 226e2, and a radio frequency amplifier 226e3. In this design, the second generator module 226e can determine the correct modulation frequency for the second frequency generator 220 using the output of an absolute RF frequency clock previously generated, in combination with the frequency divider 226e1 and the phase-locked loop 226e1.

In Figure 2, two lenses 252, 254 direct the second generator beam 220a to the second filter 222.

The second filter control module 226f controls the second filter 222 in a closed loop fashion. As provided above, the second filter 222 is controlled to transmit any one single, second frequency line 22b. Stated differently, depending upon the target frequency command 213, the second filter 222 can be selectively controlled to transmit any one of the second frequency lines 22b, while blocking all the others. For example, the second filter control module 226f can control the second filter 222 to transmit the desired second frequency line that is equal to the target frequency command 213.

In Figure 2, (i) a lens 256 directs the second filter beam 222a; (ii) a beam splitter 258 splits the second filter beam 222a, and diverts a portion of the second filter beam 222a to a sensor 260 (e.g., a photodetector), and (iii) a lens 262 directs the second filter beam 222a at the amplifier 224. In this design, the second filter beam 222a is sampled with the sensor 260 to ensure that the filter pass band of the second filter 222 is coincident with the target frequency command 213. With this design, the information from the sensor 260 is directed to the second filter module 226f to control the second filter 222 in a closed loop fashion to ensure that the filter pass band of the second filter 222 is coincident with the target frequency command 213.

The amplifier 224 amplifies the second filter beam 222a to provide the source beam 212 without changing the second filter frequency.

In Figure 2, (i) a lens 264 directs the source beam 212; (ii) a beam splitter 266 splits the source beam 212, and diverts a portion of the source beam 212 to a sensor 268 (e.g., a photodetector), and (iii) a lens 270 directs the source beam 212 at the optical fiber 230 to fiber couple the source beam 212. In this design, the source beam 212 is sampled with the sensor 268 to ensure that the source beam 212 is at the target frequency command 213 and to measure the amplification. With this design, the information from the sensor 268 is directed to the amplifier control module 226g to control the amplifier 224 in a closed loop fashion to accurately generate the desired output beam 212.

In Figure 2, the light source 210 is comprised of a series of novel integrated electro-optical phase modulators configured as an electro-optical comb generator, a phase modulator, and a tunable drop filter. The light source 210 can be a compact opto-mechanical assembly comprised of a single frequency external cavity laser, four integrated electro- optical devices (comb generator, two drop filters and a phase modulator), an off-the-shelf amplifier, and a custom-built reference cell assembly, with light directed, split, and coupled into and out of each waveguided device using discrete optical components reliably mounted on a miniature stable optical "bench".

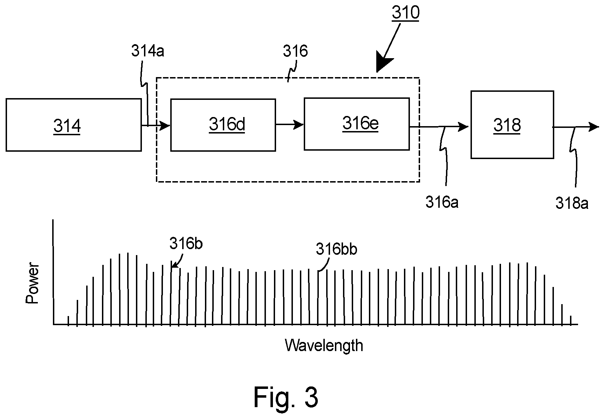

Figure 3 is a simplified block illustration of a yet another implementation of the light source 310. More specifically, Figure 3 illustrates (i) the single frequency emitter assembly 314 has generated the single frequency emitter beam 314a (illustrated as an arrow); (ii) the first frequency generator 316 has generated the first frequency beam 316a (illustrated as an arrow); and (iii) the first filter 318 has created the first filter beam 318a. These components can be similar to the corresponding components described above and illustrated in Figures 1 and 2. Further, the design of Figure 3 can be implemented into the design of Figure 1 and 2.

In the non-exclusive implementation of Figure 3, the first frequency generator 316 is a twelve nanometer wide, integrated thin film LiNbO4 electro-comb generator that includes an AM modulator 316d, and a PM modulator 316e. Figure 3 also illustrates one, non-exclusive example of the first frequency lines 316b generated. In this example, the amplitude of the first frequency lines 316b varies as you move away from the carrier frequency 316bb.

While the particular designs as shown and disclosed herein is fully capable of obtaining the objects and providing the advantages herein before stated, it is to be understood that it is merely illustrative of the presently preferred embodiments of the invention and that no limitations are intended to the details of construction or design herein shown other than as described in the appended claims.

## Claims

1. A light source that generates a source beam having a source frequency, the light source being tunable to a target frequency, the light source comprising:
an emitter assembly that emits an emitter beam;
a first frequency generator that receives the emitter beam and generates a first generator beam that consists of a plurality of discrete, spaced apart, first frequency lines; and
a first filter that filters the first generator beam to transmit a first filter beam that primarily includes only one of the first frequency lines.

2. The light source of claim 1 wherein one of the first frequency lines of the first generator beam is selected, and wherein the first filter is tuned to transmit the selected, first frequency line, while blocking the other first frequency lines.

3. The light source of claim 2 wherein the selected, first frequency line corresponds to the target frequency.

4. The light source of any one of claims 1 to 3 further comprising a second frequency generator that receives the first filter beam and converts the first filter beam into a second generator beam that includes at least one second frequency line.

5. The light source of claim 4 further comprising a second filter that is tuned to filter the second generator beam to provide a second filter beam that primarily includes only one second frequency line.

6. The light source of claim 5 further comprising an amplifier that amplifies the second filter beam to provide the source beam.

7. The light source of any one of claims 5 or 6 further comprising an optical fiber having a fiber facet that receives the source beam.

8. The light source of any one of claims 1 to 7 wherein the first frequency lines of the first generator beam are equally spaced.

9. The light source of any one of claims 1 to 8 wherein one of the first frequency lines of the first generator beam is selected based on the target frequency of the source beam, and wherein the first filter is tuned to transmit the selected, first frequency line, while blocking the other first frequency lines.

10. The light source of any one of claims 5 to 9 wherein the second frequency generator is tuned so that one of the second frequency lines is approximately equal to the target frequency, and wherein the second filter is tuned to transmit the second frequency line that is approximately equal to the target frequency, while blocking the other second frequency lines.

11. The light source of any one of claims 4 to 10 wherein the first frequency generator generates at least ten, first frequency lines, and wherein the second frequency generator generates at least three, second frequency lines.

12. The light source of claim 1 wherein one of the first frequency lines of the first filter beam corresponds to the target frequency; wherein the first filter that is tuned to filter the first generator beam to transmit a first filter beam that includes the first frequency line that corresponds to the target frequency, while blocking the other first frequency lines; wherein the light source includes (i) a second frequency generator that receives the first filter beam and converts the first filter beam into a second generator beam that includes at least one second frequency line, and (ii) a second filter that filters the second generator beam to provide a second filter beam that primarily includes only one of the second frequency lines.

13. The light source of claim 12 wherein the second frequency generator is tuned so that one of the second frequency lines is approximately equal to the target frequency, and wherein the second filter is tuned to transmit the second frequency line that is approximately equal to the target frequency, while blocking the other second frequency lines.

14. The light source of claim 1 further comprising a second frequency generator that receives the first filter beam and converts the first filter beam into a second generator beam that consists of a plurality of discrete, spaced apart second frequency lines; wherein the second frequency generator is tuned so that one of the second frequency lines is approximately equal to the target frequency; and a second filter that filters the second generator beam to provide a second filter beam; wherein the second filter is tuned to transmit the second frequency line that is approximately equal to the target frequency, while blocking the other second frequency lines.

15. A method for generating a source beam having a source frequency that is tunable to a target frequency comprises:
emitting an emitter beam with an emitter assembly;
converting the emitter beam to a first generator beam with a first frequency generator, the first generator beam including a plurality of discrete, spaced apart, first frequency lines; and
filtering the first generator beam with a first filter to transmit a first filter beam that includes primarily only one of the first frequency lines.
